# EUROPEAN PATENT SPECIFICATION

(11) **EP 0 964 075 B1**
(45) Date of publication and mention of the grant of the patent: **11.05.2005**
(21) Application number: 99304538.4
(22) Date of filing: 10.06.1999
(51) Int. Cl.: C23C 16/44, B01D 53/00

(54) **Metal organic gas scrubber**
Gasreiniger für metallorganische Gase
Epurateur de gaz métallo-organique

(43) Date of publication of application: 15.12.1999
(73) Proprietor: The BOC Group plc, Windlesham Surrey GU20 6HJ (GB)
(72) Inventor: Abreu, Raul, Horsham, West Sussex RH12 5TH (GB); Clark, John, East Grindstead, West Sussex RH19 3BW (GB); Watson, Allister, Fife, Scotland KY2 6NN (GB); Davis, Patrick, Horsham, West Sussex RH12 5EU (GB)
(74) Representative: Bousfield, Roger James

(56) References cited:
- EP-A- 0 296 720
- EP-A- 0 811 413
- EP-A- 0 823 279

## Description

The present invention relates to apparatus for removing metal components from the waste gas or gases of a metal-organic process and in particular apparatus for incorporation in vacuum systems for reacting with and separating the metal component of waste gases from semi-conductor processes.

In, for example, the semi-conductor industry various metal-organic precursors are used in the chemical vapour deposition (CVD) of metallic interconnects or barrier layers on silicon wafers. Two desirable features of these metal-organic precursors are a) a reasonable vapour pressure that allows accurate and repeatable delivery of the precursor to the process equipment; and b) high metal deposition rates at low temperatures. These CVD techniques are carried out at low pressure and therefore require vacuum systems to operate efficiently. By design a typical application consumes only part of the metal-organic process gas. The unreacted gas and other process by-products must be pumped away by the vacuum system connected to the process equipment.

Under certain conditions the process waste gases can react in the process equipment and the vacuum equipment thereby causing metal to be deposited on various surfaces of the process equipment and the vacuum equipment. The main adverse effects of the metal deposits in the vacuum system are loss of conductance and interference with rotating mechanisms. Unreacted metal-organic gas can also cause metal contamination if allowed to exhaust to the environment.

A solution to the problem is to force the waste gases to react to completion in a thermal, low pressure reactor placed between the process equipment and the vacuum equipment.

The most important requirements of a thermal low pressure reactor are high reaction efficiency and the ability to maintain high conductance as the metal deposits within its interior. The conductance of such a reactor decreases as metal deposits inside the reactor and, as an example, in the case of a long cylindrical tube in continuum flow the conductance varies directly as the fourth power of the diameter of the tube and inversely as the length of the tube. A decrease in the tube diameter through metal deposition will cause a rapid loss of conductance. In the case of a high surface area to volume ratio reactor where the diameter is much smaller than the length, a high degree of efficiency may be obtained at the expense of rapid conductance loss.

It is an aim of the present invention to provide an apparatus for removing a metal component from any unreacted metal-organic gas after use of said gas in a metal-organic process which apparatus is adapted for attachment between the process equipment and the vacuum equipment and in which the metal collection pattern built into the design of the apparatus maximises conductance whilst maintaining a large collection capacity.

According to the present invention, an apparatus for removing the metal-component from any unreacted metal-organic gas after use of said gas in a metal-organic vapour deposition process, comprises a main body having an inlet and spaced therefrom an outlet, a element located within the main body and one or more vanes extending between the external surface of the element and the internal surface of the main body to define with said surfaces one or more channels for the tortuous passage of the unreacted metal-organic gas between the inlet towards the outlet, and means for controlling the temperature of the tubular element.

Preferably, the element is a hollow tubular element on which a plurality of vanes are attached and extend radially outwardly from the external surface of the tubular element and touch the internal surface of the main body, the vanes extending along the length of the tubular element to form a plurality of interconnecting longitudinal channels.

Preferably the apparatus is designed as a disposable item.

An embodiment of the invention will now be described, by way of example, reference being made to the Figures of the accompanying diagrammatic drawings in which:-
Figure 1 is a schematic block diagram illustrating a vacuum process chamber and ancillary equipment for a low pressure metal-organic vapour deposition process;
Figure 2 is a partially broken perspective view of an apparatus for the removal of a metal component from any unreacted metal-organic gas after use of said gas in the vacuum process chamber of Figure 1 according to the present invention.
Figure 3 is a perspective view of a detail of the apparatus shown in Figure 2;
Figure 4 is a diagram illustrating the flow of unreacted metal-organic gas when passing through the apparatus of Figure 2; and
Figure 5 illustrates a selection of vane arrangements which may be used in the apparatus shown in Figure 2.

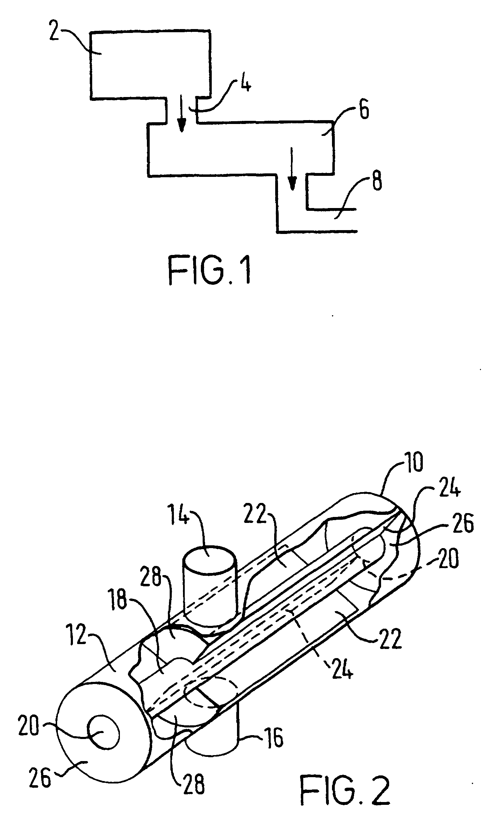

Referring initially to Figure 1, there is shown for use in a low pressure (vacuum) metal-organic chemical vapour deposition process, a vacuum process chamber 2 containing a wafer or wafers. In use, a mixture of gases, for example a copper precursor such as Cu(hfac)(vtms) and inert carrier gases pass through the process chamber 2 for deposition of the copper component on the wafers. Any excess unreacted copper precursor, reacted copper precursor by-products and the inert carrier gases leave the vacuum process chamber 2 as waste gases passing through a fore-line 4, vacuum pump 6 into exhaust line 8.

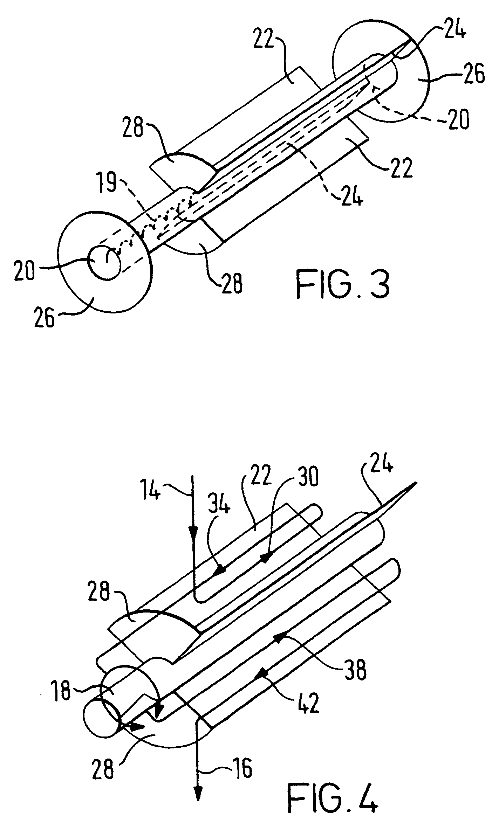

Referring now to Figures 2 and 3 which illustrate an apparatus 10 according to the present invention for removing a metal component of any unreacted metal-organic gas after use in the metal-organic vapour deposition process. The apparatus 10 is insertable within the fore-line 4 that is, before the vacuum pump 6 and comprises a main body 12 made, for example, of stainless steel which has an inlet 14 and spaced therefrom an outlet 16. As shown, the main body 12, the inlet 14 and the outlet 16 each have a circular cross-sectional configuration and the inlet 14 is located adjacent the outlet 16.

Mounted concentrically within the main body 12 along the longitudinal axis of the main body 12 is an element 18 in the form of an elongate hollow tube which has a substantially smaller cross-sectional configuration than that of the main body 12. The tubular element 18 is made, for example, from stainless steel and within the tubular element 18 is located means in the form of a heater 19 (not shown) for controlling the temperature of the tubular element 18. Attached to the tubular element 18 are a plurality of short vanes 22 running parallel to the element 18 and one or more long vanes 24 also running parallel to the element 18. The vanes 22, 24 are made from a metallic material, for example stainless steel and the dimensional configuration of the vanes is such that they extend radially from the tubular element 18 to touch the internal surface of the main body 12 at all points along their length. Also attached to the tubular element 18 are one or more plates 28 made for example from stainless steel. As shown, the plates 28 are attached to one short vane 22 and one long vane 24 adjacent the inlet 14 and the outlet 16. As shown the arrangement of short vanes 22 and long vanes 24 is such that the short vanes alternate with the long vanes around the tubular element 18.

End plates 26 are provided one at each end of the main body 12 each with an access opening 20 to allow the insertion of the heater 19 into the interior of the tubular element 18. The end plates 26 are each made from a metallic material for example stainless steel.

Referring also to Figure 4, it will be evident that the vanes 22, 24 together with the outer surface of the tubular element 18 and the inner surface of the main body 12 define a plurality of channels 30, 34, 38, 42 which are intercommunicating to provide a tortuous flowpath for the flow of waste gas between the inlet 14 and the outlet 16.

In use, the apparatus 10 is releasably attached by means of flanges (not shown) at a pre-determined location in the vacuum fore-line 4. Thereafter energy is applied to the heater 19 located in the interior of the tubular element 18 and said element 18 together with the vanes 22 and 24 and the plates 28 are temperature controlled to give a thermally adjustable reactor surface where the metal component(s) can be deposited from the waste gas flowing through the apparatus 10. The metal component(s) will initially be deposited at the roots of the vanes 22, 24 and therefore the device will offer very little resistance to the flow of waste gases through the fore-line 4. At all times during operation of the apparatus 10 the temperature of the main body 12 remains at ambient, that is, relatively cool with respect to the tubular element 18 and the vanes 22, 24. The specific arrangement of the vanes 22, 24 as described in the above embodiment provide a long flowpath between the inlet 14 and the outlet 16 such that the waste gas has a relatively long residence time thereby encouraging deposition of the metal component of the waste gas. The specific arrangement described has been found to provide a large internal volume capable of depositing large quantities of metal component whilst minimising the resistance to the flow of waste gases through the apparatus 10.

Although in the above described embodiment reference has been made to a hollow tubular element, clearly a temperature control element of any type or shape can be employed with vanes attached directly to it.

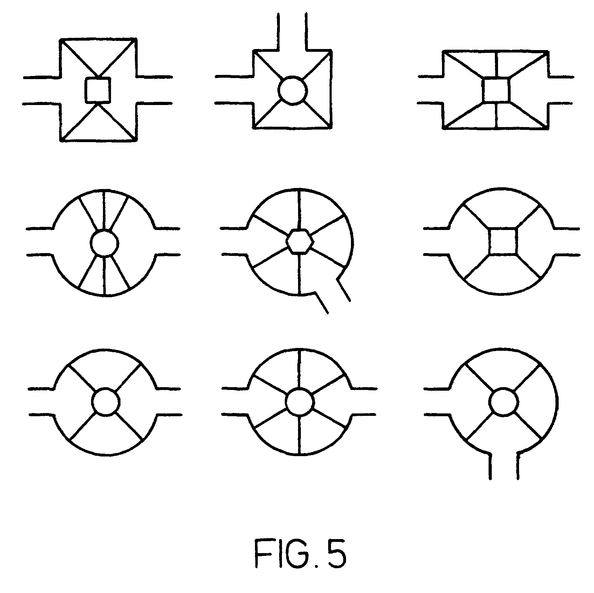

Turning now to Figure 5 this illustrates various configurations of vanes which will give different flowpath lengths and volumes within the device 10 which can be selected according to the process conditions.

Although the above embodiment has been described in connection with a low pressure metal-organic chemical vapour deposition process it will be clear that the apparatus disclosed could be equally as effective in other processes, for example, plasma enhanced chemical vapour deposition where waste gases will flow through the apparatus 10 for the removal of metal components at variable temperatures.

## Claims

1. An apparatus (10) for removing a metal component from any unreacted metal-organic gas after use of said gas in a metal-organic vapour deposition process comprising a main body (12) having an inlet (14) and spaced therefrom an outlet (16), a tubular element (18) located concentrically within the main body (12) and means (19) for controlling the temperature of the tubular element (18), **characterised in that** a plurality of vanes (22, 24) extend radially outwardly from the tubular element (18) towards the internal surface of the main body (12), the vanes extending along the length of the tubular element (18) to form a plurality of intercommunicating longitudinal channels that are closed at one end thereby defining a tortuous passage for the unreacted metal-organic gas extending between the inlet (14) towards the outlet (16).

2. An apparatus as claimed in claim 1, in which plates (28) are provided on the tubular element (18) for guiding the unreacted metal-organic gas through the longitudinal channels in a plurality of passes along the length of the main body (12).

3. An apparatus as claimed in claims 1 or 2, in which the means (19) for controlling the temperature of the tubular element (18) is a removable heater located within the tubular element.

4. An apparatus as claimed in claim 3, in which, in use, the heater (19) raises the temperature of the tubular element (18) and the vanes (22, 24), the temperature of the main body (12) remaining at ambient.

5. An apparatus as claimed in any one of claims 1 to 4, in which flanges are provided for attachment of the apparatus to a vacuum line.

6. An apparatus as claimed in any one of claims 1 to 5, in which the apparatus (10) is disposable.

## Patentansprüche

1. Einrichtung (10) zum Abscheiden einer Metallkomponente von irgendwelchem unreagierten metall-organischem Gas nach Gebrauch dieses Gases in einem metall-organischem Bedampfungsverfahren, mit einem Hauptgehäuse (12) mit einem Einlaß (14) und davon beabstandet mit einem Auslaß (16), einem rohrförmigen Element (18), das konzentrisch in dem Hauptgehäuse (12) angeordnet ist, und mit Mitteln (19) zur Steuerung der Temperatur des rohrförmigen Elements (18), **dadurch gekennzeichnet, daß** eine Mehrzahl von Flügeln (22, 24) radial auswärts von dem rohrförmigen Element (18) zur Innenwand des Hauptgehäuses (12) hin wegragen, wobei die Flügel sich entlang der Länge des rohrförmigen Elements (18) erstrecken und eine Mehrzahl von miteinander in Verbindung stehenden Längskanälen bilden, die jeweils an einem Ende geschlossen sind und dadurch einen gewundenen Pfad für das unreagierte metall-organische Gas bilden, der zwischen dem Einlaß (14) und dem Auslaß (16) verläuft.

2. Einrichtung nach Anspruch 1, wobei Platten (28) auf dem rohrförmigen Element (18) vorgesehen sind, um das unreagierte metall-organische Gas durch die Längskanäle in Gestalt einer Mehrzahl von Durchgängen entlang der Länge des Hauptgehäuses (12) zu führen.

3. Einrichtung nach Anspruch 1 oder 2, wobei die Mittel (19) zur Steuerung der Temperatur des rohrförmigen Elements (18) ein herausnehmbares Heizgerät umfassen, das innerhalb des rohrförmigen Elements angeordnet ist.

4. Einrichtung nach Anspruch 3, bei welcher im Betrieb das Heizgerät (19) die Temperatur des rohrförmigen Elements (18) und der Flügel (22, 24) anhebt, während die Temperatur des Hauptgehäuses (12) auf Umgebungstemperatur bleibt.

5. Einrichtung nach einem der Ansprüche 1 bis 4, wobei Flansche zur Befestigung der Einrichtung an einer Vakuumleitung vorgesehen sind.

6. Einrichtung nach einem der Ansprüche 1 bis 5, wobei die Einrichtung (10) ein Einwegartikel ist.

## Revendications

1. Dispositif (10) pour éliminer un composant métallique d'un quelconque gaz organométallique n'ayant pas réagi après utilisation dudit gaz dans un processus de dépôt organométallique en phase vapeur, comprenant un corps principal (12) ayant une entrée (14) et, à distance de celle-ci, une sortie (16), un élément tubulaire (18) situé de manière concentrique à l'intérieur du corps principal (12), et des moyens (19) pour réguler la température de l'élément tubulaire (18), ***caractérisé en ce qu*'**une pluralité de palettes (22, 24) s'étendent radialement vers l'extérieur à partir de l'élément tubulaire (18) en direction de la surface interne du corps principal (12), les palettes s'étendant sur la longueur de l'élément tubulaire (18) pour former une pluralité de canaux longitudinaux intercommuniquants qui sont fermés à une extrémité, définissant ainsi un passage tortueux pour le gaz organométallique n'ayant pas réagi, passage s'étendant entre l'entrée (14) et la sortie (16).

2. Dispositif selon la revendication 1, dans lequel les palettes (28) sont prévues sur l'élément tubulaire (18) pour guider le gaz organométallique le long des canaux longitudinaux dans une pluralité de passages sur la longueur du corps principal (12).

3. Dispositif selon les revendications 1 ou 2, dans lequel les moyens (19) pour réguler la température de l'élément tubulaire (18) sont un élément chauffant amovible situé à l'intérieur de l'élément tubulaire.

4. Dispositif selon la revendication 3, dans lequel, à l'utilisation, l'élément chauffant (19) fait monter la température de l'élément tubulaire (18) et des palettes (22, 24), la température du corps principal (12) demeurant la température ambiante.

5. Dispositif selon l'une quelconque des revendications 1 à 4, dans lequel des brides sont prévues pour la réunion du dispositif à une canalisation à vide.

6. Dispositif selon l'une quelconque des revendications 1 à 5, dans lequel le dispositif (10) est un article à jeter après usage.
